# EUROPEAN PATENT APPLICATION

(11) **EP 4 502 537 A1**
(43) Date of publication of application: **05.02.2025**
(21) Application number: 22935714.0
(22) Date of filing: 15.12.2022
(51) Int. Cl.: G01C 19/5783, H10N 30/00, H10N 30/01, H10N 30/045, H10N 30/082, H10N 30/088, H10N 30/30

(54) **METHOD FOR MANUFACTURING FERROELECTRIC FILM-FORMING SUBSTRATE AND FERROELECTRIC FILM-FORMING SUBSTRATE**

(30) Priority: 30.03.2022 JP 2022057216
(71) Applicant: Sumitomo Precision Products Co., Ltd., Hyogo 660-0891 (JP)
(72) Inventor: KIUCHI, Mario, Amagasaki-shi, Hyogo 660-0891 (JP)
(74) Representative: Viering, Jentschura & Partner mbB Patent- und Rechtsanwälte
(86) International application number: PCT/JP2022/046149
(87) International publication number: WO 2023/188586

(57) **Abstract**

A method for manufacturing a piezoelectric film deposition substrate (100) according to this present invention includes forming a piezoelectric film (3) on or above the lower electrode (2) with the mask (5) being attached on or above the lower electrode; forming an upper electrode (4) on the piezoelectric film with the mask being attached on or above the lower electrode; forming a the lower-electrode-exposed part (2a) by detaching the mask from the lower electrode; and subjecting the piezoelectric film to polarization by applying a voltage between the lower-electrode-exposed part and the upper electrode.

## Description

### Technical Field

The present invention relates to a method for manufacturing a ferroelectric film deposition substrate and a ferroelectric film deposition substrate, in particular to a method for manufacturing a ferroelectric film deposition substrate by subjecting a ferroelectric film to polarization and a ferroelectric film deposition substrate including a ferroelectric film subjected to polarization.

### Background Art

Methods for manufacturing a thin film micromechanical resonator gyro subjecting a ferroelectric film to polarization are known. Such a method for manufacturing a thin film micromechanical resonator gyro is disclosed in Japanese Patent Laid-Open Publication No. JP 2003-302222, for example.

The above Japanese Patent Laid-Open Publication No. JP 2003-302222 discloses a method for manufacturing a thin film micromechanical resonator gyro subjecting a ferroelectric film to polarization. In this manufacturing method, a lower electrode, a piezoelectric thin film, and an upper electrode are formed on a silicon wafer in this order, and the piezoelectric thin film and the upper electrode are patterned by photolithography. Accordingly, a plurality of thin-film micromechanical resonator gyros are formed on the silicon wafer. Subsequently, the silicon wafer on which the plurality of thin-film micromechanical resonator gyros are formed is divided so that the plurality of thin-film micromechanical resonator gyros become separated pieces. In this manufacturing method, in patterning of the piezoelectric thin film and the upper electrode by using photolithography, exposed parts of the lower electrodes for the polarization are formed by photolithography. Subsequently, an electrically conductive sheet is placed to cover the upper electrodes of thin film micromechanical resonator gyros, and the piezoelectric thin films of the thin film micromechanical resonator gyros are subjected to the polarization by one operation by applying a voltage between the exposed parts of the lower electrodes and the conductive sheets, which cover the upper electrodes.

### Prior Art

### Patent Document

Patent Document 1: Japanese Patent Laid-Open Publication No. JP 2003-302222

### Summary of the Invention

### Problems to be Solved by the Invention

In the method for manufacturing a thin film micromechanical resonance gyro stated in the above Japanese Patent Laid-Open Publication No. JP 2003-302222, although the piezoelectric thin films can be subjected to the polarization by one operation, a complicated process such as formation of a resist film and etching of the resist film is required to form the exposed parts of the lower electrodes by using photolithography. For this reason, there is a problem that it is difficult to easily form the exposed parts of the lower electrodes (lower-electrode-exposed parts) in the case in which the piezoelectric thin films (ferroelectric films) are polarized by one operation.

The present invention is intended to solve the above problem, and one object of the present invention is to provide a method for manufacturing a ferroelectric film deposition substrate and a ferroelectric film deposition substrate capable of easily forming a lower-electrode-exposed part even in a case in which a ferroelectric film is polarized by one operation.

### Means for Solving the Problems

In order to attain the aforementioned object, a method for manufacturing a ferroelectric film deposition substrate according to a first aspect of the present invention is a method for manufacturing a ferroelectric film deposition substrate to be divided into a plurality of pieces as devices, the method including preparing a substrate; forming a lower electrode on or above the substrate; attaching a mask on or above the lower electrode; forming a ferroelectric film on or above the lower electrode with the mask being attached on or above the lower electrode; forming an upper electrode or above on the ferroelectric film with the mask being attached on or above the lower electrode; forming a lower-electrode-exposed part by removing the mask from the lower electrode to expose a part of the lower electrode on or above which neither the ferroelectric film nor the upper electrode is formed; and subjecting the ferroelectric film to polarization by applying a voltage between the lower-electrode-exposed part and the upper electrode.

In the method for manufacturing the ferroelectric film deposition substrate according to the first aspect of the present invention, as discussed above, attaching a mask on or above the lower electrode; forming a ferroelectric film on or above the lower electrode with the mask being attached on or above the lower electrode; forming an upper electrode on the ferroelectric film with the mask being attached on or above the lower electrode; forming a lower-electrode-exposed part by removing the mask from the lower electrode to expose a part of the lower electrode on or above which neither the ferroelectric film nor the upper electrode is formed; and subjecting the ferroelectric film to polarization by applying a voltage between the lower-electrode-exposed part and the upper electrode are provided. According to this configuration, it possible to subject the ferroelectric film to polarization by using one operation prior to dividing the ferroelectric film deposition substrate into a plurality of pieces. Also, since the lower-electrode-exposed part is formed without formation of the ferroelectric film and the upper electrode by using a mask, it is possible to easily form the lower-electrode-exposed part without requiring a complicated process as compared with a case in which the lower-electrode-exposed part is formed by photolithography including formation of a resist film and etching of the resist film. Consequently, the lower-electrode-exposed part can be easily formed even in a case in which the ferroelectric film is subjected to polarization by using one operation. In addition, since the ferroelectric film can be subjected to polarization by using one operation prior to dividing the ferroelectric film deposition substrate into a plurality of pieces, it possible to reduce time required for polarization of the ferroelectric film as compared with a case in which the ferroelectric film deposition substrate is divided into a plurality of pieces, and the plurality of pieces of the ferroelectric film are separately subjected to polarization.

In the method for manufacturing the ferroelectric film deposition substrate according to the aforementioned first aspect, it is preferable that the attaching the mask on or above the lower electrode includes attaching the mask on or above at least one part of an outer periphery of the lower electrode that is included in an exclusion area that is not used as the device; and that the forming the lower-electrode-exposed part includes forming the lower-electrode-exposed part in the at least one part of the outer periphery of the lower electrode, which is included in the exclusion area. According to this configuration, since the lower-electrode-exposed part can be formed by utilizing the exclusion area, which is not used for the device, it is possible to prevent that an area usable for the device is reduced by formation of the lower-electrode-exposed part. Consequently, it is possible to prevent reduction of a yield of the device. In addition, since the outer periphery of the lower electrode is an area on which the mask can be attached more easily than an inner periphery, it is possible to more easily attach the mask.

In this configuration, it is preferable that the attaching the mask on or above the lower electrode includes attaching the mask in an arc shape having a fixed curvature on or above the at least one part of the outer periphery of the lower electrode; and that the forming the lower-electrode-exposed part includes forming the lower-electrode-exposed part in the arc shape having the fixed curvature in the at least one part of the outer periphery of the lower electrode. According to this configuration, since the lower-electrode-exposed part has an arc shape having a fixed curvature, it is possible to easily form the lower-electrode-exposed part to be included in the exclusion area.

In the method for manufacturing the ferroelectric film deposition substrate according to the aforementioned first aspect, it is preferable that the subjecting the ferroelectric film to polarization includes subjecting the ferroelectric film to polarization by applying the voltage between the lower-electrode-exposed part and the upper electrode prior to applying processing for the device to the upper electrode. According to this configuration, since polarization can be performed before the upper electrode is electrically separated by applying processing for the device to the upper electrode, an electrically conductive element is not required dissimilar to a case in which the upper electrode is electrically separated by applying processing for the device to the upper electrode, and polarization is then performed by connecting the separated upper electrodes to each other by using the electrically conductive element. Consequently, it is possible to easily perform polarization.

In the method for manufacturing the ferroelectric film deposition substrate according to the aforementioned first aspect, it is preferable that the ferroelectric film is a piezoelectric film. According to this configuration, it is possible to easily form the lower-electrode-exposed part even in a case in which the piezoelectric film is subjected to polarization by using one operation.

In order to attain the aforementioned object, a ferroelectric film deposition substrate according to a second aspect of the present invention is a ferroelectric film deposition substrate to be divided into a plurality of pieces as devices, the ferroelectric film deposition substrate including a substrate; a lower electrode formed on or above the substrate; a ferroelectric film formed on or above the lower electrode; and an upper electrode formed on or above the ferroelectric film and not subjected to processing for the device, wherein the lower electrode includes a lower-electrode-exposed part that is connected to at least one part of an outer periphery of the substrate and on or above which neither the ferroelectric film nor the upper electrode is formed, and the ferroelectric film has been subjected to polarization.

In the ferroelectric film deposition substrate according to the second aspect of the present invention, as discussed above, the lower electrode includes a lower-electrode-exposed part that is connected to at least one part of an outer periphery of the substrate and on or above which neither the ferroelectric film nor the upper electrode is formed; the upper electrode is not subjected to processing for the device; and the ferroelectric film has been subjected to polarization. According to this configuration, it possible to provide a ferroelectric film deposition substrate including a ferroelectric film subject to polarization by using one operation prior to dividing the ferroelectric film deposition substrate into a plurality of pieces. Also, since the lower-electrode-exposed part is formed without formation of the ferroelectric film and the upper electrode, it is possible to easily form the lower-electrode-exposed part without requiring a complicated process as compared with a case in which the lower-electrode-exposed part is formed by photolithography including formation of a resist film and etching of the resist film. Consequently, it is possible to provide a ferroelectric film deposition substrate including the lower-electrode-exposed part, which can be easily formed even in a case in which the ferroelectric film is subjected to polarization by using one operation. In addition, since polarization can be performed before pieces of the upper electrodes are electrically separated from each other by applying processing for the device to the upper electrode, it is possible to easily perform polarization as compared with a case in which the pieces of the upper electrodes are electrically separated from each other by applying processing for the device to the upper electrode, and polarization is then performed by connecting the upper electrodes of the devices to each other by using an electrically conductive element.

### Effect of the Invention

According to this invention, as discussed above, the lower-electrode-exposed part can be easily formed even in a case in which the ferroelectric film is polarized by one operation.
FIG. 1 is a plan view showing a piezoelectric film deposition substrate according to one embodiment.
FIG. 2 is a cross-sectional view showing the piezoelectric film deposition substrate according to the one embodiment.
FIG. 3 is a plan view showing a substrate in a manufacturing process according to the one embodiment.
FIG. 4 is a cross-sectional view showing the substrate in the manufacturing process according to the one embodiment.
FIG. 5 is a plan view showing the substrate with a lower electrode being formed in a manufacturing process according to the one embodiment.
FIG. 6 is a cross-sectional view showing the substrate with the lower electrode being formed in the manufacturing process according to the one embodiment.
FIG. 7 is a plan view showing the substrate with a mask being attached in a manufacturing process according to the one embodiment.
FIG. 8 is a cross-sectional view showing the substrate with the mask being attached in the manufacturing process according to the one embodiment.
FIG. 9 is a plan view showing the substrate with a piezoelectric film being formed in a manufacturing process according to the one embodiment.
FIG. 10 is a cross-sectional view showing the substrate with the piezoelectric film being formed in the manufacturing process according to the one embodiment.
FIG. 11 is a plan view showing the substrate with an upper electrode being formed in a manufacturing process according to the one embodiment.
FIG. 12 is a cross-sectional view showing the substrate with the upper electrode being formed in the manufacturing process according to the one embodiment.
FIG. 13 is a plan view showing the substrate with the mask being detached in a manufacturing process according to the one embodiment.
FIG. 14 is a cross-sectional view showing the substrate with the mask being detached in the manufacturing process according to the one embodiment.
FIG. 15 is a schematic view showing a manufacturing process of subjecting the substrate to polarization according to the one embodiment.
FIG. 16 is a plan view illustrating division of the piezoelectric film deposition substrate into a plurality of pieces according to the one embodiment.
FIG. 17 is a plan view showing a piezoelectric film deposition substrate according to a first modified embodiment of the one embodiment.
FIG. 18 is a plan view showing a piezoelectric film deposition substrate according to a second modified embodiment of the one embodiment.

### Modes for Carrying Out the Invention

Embodiments according the present invention will be described with reference to the drawings.

### (Configuration of Piezoelectric Film Deposition Substrate)

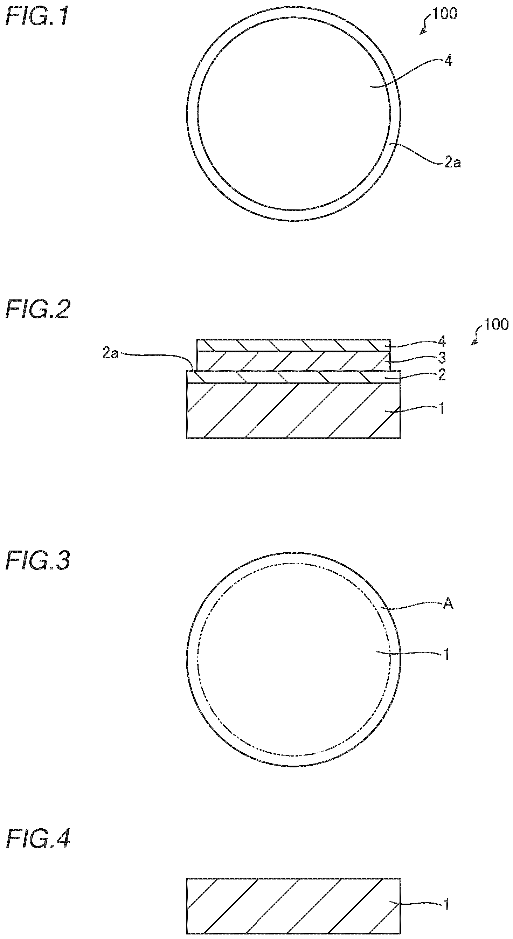

The following description describes a configuration of a piezoelectric film deposition substrate 100 according to one embodiment of the present invention with reference to FIGS. 1 and 2. The piezoelectric film deposition substrate 100 is an example of a "ferroelectric film deposition substrate" in the claims.

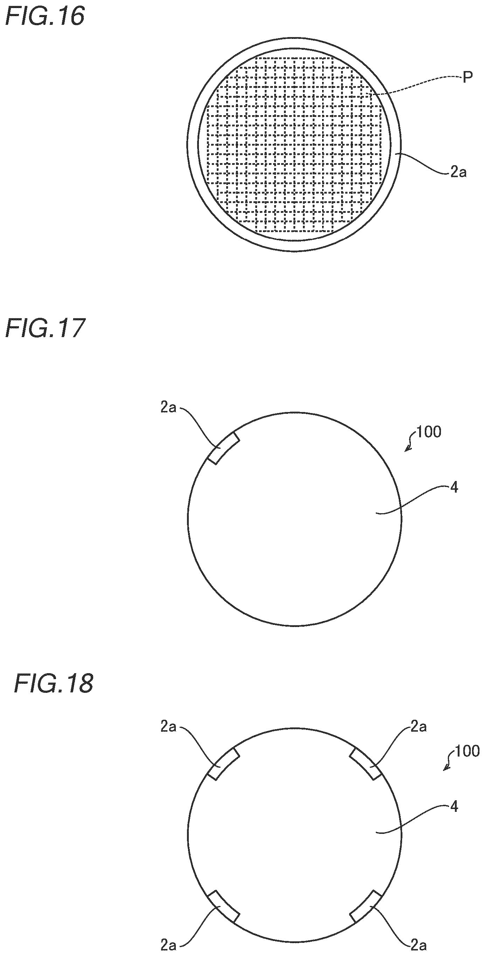

The piezoelectric film deposition substrate 100 is a piezoelectric film deposition substrate to be divided into a plurality of pieces P (see FIG. 16) as devices. Each of the plurality of pieces P becomes the device. For example, the device is a MEMS (Micro Electro Mechanical Systems) device. In addition, the MEMS device is a MEMS gyroscopic element, for example. The devices and the MEMS devices are not limited to particular devices.

As shown in FIGS. 1 and 2, the piezoelectric film deposition substrate 100 includes a substrate 1, a lower electrode 2, a piezoelectric film 3, and an upper electrode 4. The piezoelectric film 3 is an example of a ferroelectric film in the claims.

The substrate 1 is a silicon wafer substrate. The substrate 1 has a circular shape. The lower electrode 2 is formed on the substrate 1. The lower electrode 2 is formed on the entire surface of the substrate 1. The lower electrode 2 is formed of a metal film such as a Pt/Ti film. In this embodiment, the lower electrode 2 includes a lower-electrode-exposed part 2a. The lower-electrode-exposed part 2a is formed by exposing a part of the lower electrode 2 on which neither the piezoelectric film 3 nor the upper electrode 4 is formed. The lower-electrode-exposed part 2a is connected to at least one part of an outer periphery of the substrate 1 (to the entire periphery of the substrate in this embodiment). The lower-electrode-exposed part 2a is formed in at least one part of the outer periphery of the lower electrode 2 that is included in an exclusion area A (see FIG. 3), which is not used as the device, in an arc shape (a ring shape in this embodiment) having a fixed curvature. The exclusion area (chip exclusion area) A is an area outside a performance assurance, and is a ring-shaped area having a width of several mm and lying inward from an outer edge of the substrate 1.

The piezoelectric film 3 is formed on the lower electrode 2. The piezoelectric film 3 is formed on the entire surface of the lower electrode 2 except for the lower-electrode-exposed part 2a. The piezoelectric film 3 is formed of a ferroelectric film such as a lead zirconate titanate (PZT) film. In this embodiment, the piezoelectric film 3 has been subjected to polarization. The upper electrode 4 is formed on the piezoelectric film 3. The upper electrode 4 is formed on substantially the entire surface of the piezoelectric film 3. The upper electrode 4 is formed of a metal film such as an Au/Ti film. Also, in this embodiment, processing for the device is not applied to the upper electrode 4. Also, processing for the device is applied to neither the lower electrode 2 nor the piezoelectric film 3. The processing for the device refers to processing for forming the upper electrode, the lower electrode or the piezoelectric film into a shape for the device. For example, processing for the device is performed by photolithography. In a case of photolithography, the processing for the device is performed by removing unnecessary parts and preserving necessary parts by using wet etching using an etching solution or dry etching using an etching gas.

### (Method for Manufacturing Piezoelectric Film Deposition Substrate)

The following description describes a method for manufacturing the piezoelectric film deposition substrate 100 with reference to FIGS. 3 to 15. The method for manufacturing the piezoelectric film deposition substrate 100 is a method for manufacturing a piezoelectric film deposition substrate to be divided into a plurality of pieces P (see FIG. 16) as devices. Here, the method for manufacturing a piezoelectric film deposition substrate 100 according to this embodiment includes preparing the substrate 1; forming the lower electrode 2 on the substrate 1; attaching a mask 5 on or above the lower electrode 2; forming the piezoelectric film 3 on the lower electrode 2 with the mask 5 being attached on or above the lower electrode 2; forming the upper electrode 4 on the piezoelectric film 3 with the mask 5 being attached on or above the lower electrode 2; forming the lower-electrode-exposed part 2a by removing the mask 5 from the lower electrode 2 to expose a part of the lower electrode 2 on which neither the piezoelectric film 3 nor the upper electrode 4 is formed; and subjecting the piezoelectric film 3 to polarization by applying a voltage between the lower-electrode-exposed part 2a and the upper electrode 4.

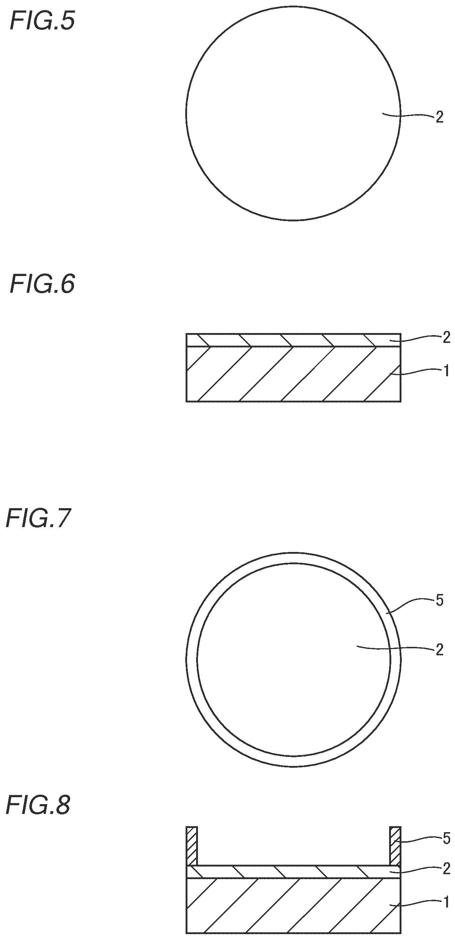

In the preparing the substrate 1, the circular silicon wafer substrate is prepared as shown in FIGS. 3 and 4. As shown in FIGS. 5 and 6, in the forming the lower electrode 2 on the substrate 1, a metal film is stacked on the entire surface of the substrate 1 by sputtering, for example. Accordingly, the lower electrode 2 is formed on the entire surface of the substrate 1. As shown in FIGS. 7 and 8, in the attaching the mask 5 on or above the lower electrode 2, the mask 5 is attached to at least one part (to the entire part in this embodiment) of the outer periphery of the lower electrode 2 that is included in the exclusion area A, which is not used as the device, and has an arc shape (ring shape in this embodiment) having a fixed curvature. Accordingly, the mask 5 covers the at least one part (the entire part in this embodiment) of the outer periphery of the lower electrode 2. The mask 5 is a stencil mask formed of a material such as metal or SiC.

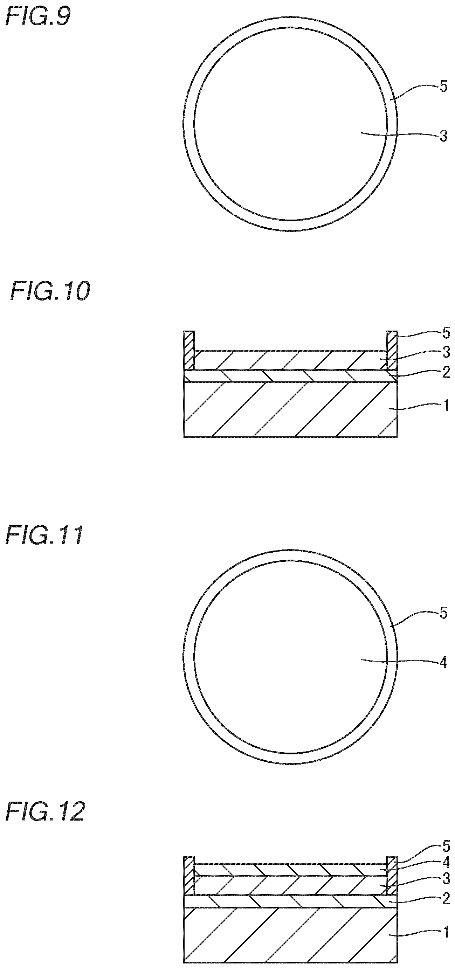

As shown in FIGS. 9 and 10, in the forming the piezoelectric film 3 on the lower electrode 2, the ferroelectric film is stacked on the entire surface of the lower electrode 2 except for the part that is covered by the mask 5 by sputtering with the mask 5 being attached on the lower electrode 2. Accordingly, the piezoelectric film 3 is formed on the entire surface of the lower electrode 2 except for the part covered by the mask 5. As shown in FIGS. 11 and 12, in the forming the upper electrode 4 on the piezoelectric film 3, a metal film is stacked on the entire surface of the piezoelectric film 3 by sputtering with mask 5 being attached on or above the lower electrode 2. Accordingly, the upper electrode 4 is formed on the entire surface of the piezoelectric film 3. Here, the upper electrode 4 is not formed on the lower electrode 2 that is covered by the mask 5.

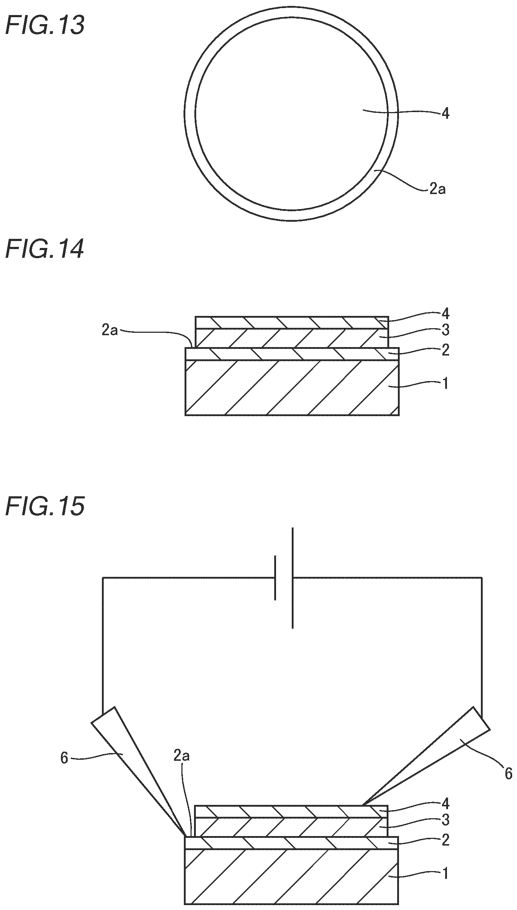

As shown in FIGS. 13 and 14, in the forming the lower-electrode-exposed part 2a, the lower-electrode-exposed part 2a is formed by removing the mask 5 from the lower electrode 2 to expose the part of the lower electrode 2 on which neither the piezoelectric film 3 nor the upper electrode 4 is formed. In this forming, the lower-electrode-exposed part 2a is formed in the at least one part of the outer periphery of the lower electrode 2, which is included in the exclusion area A (see FIG. 3), in the arc shape (a ring shape in this embodiment) having the fixed curvature. Also, the mask 5 is removed from the lower electrode 2 immediately after the forming the upper electrode 4 on the piezoelectric film 3. The mask 5 may be disposable or reused. Also, in a case of the mask is reused, the mask may be cleaned and then reused. In the case in which the mask is cleaned and then reused, it is possible to prevent that substances that adhere to the mask 5 in previous manufacturing of the piezoelectric film deposition substrate 100 adversely affects this manufacturing of the piezoelectric film deposition substrate 100.

As shown in FIG. 15, in the subjecting the piezoelectric film 3 to polarization, the piezoelectric film 3 is subjected to polarization by applying a voltage between the lower-electrode-exposed part 2a and the upper electrode 4 through probes 6 with the probes 6 being in contact with the lower-electrode-exposed part 2a and the upper electrode 4. Spontaneous polarization orientations in the piezoelectric film 3 are aligned in one orientation by the polarization. Here, in the polarization, one probe 6 may be in contact with one position of the lower-electrode-exposed part 2a while another probe 6 may be in contact with one position of the upper electrode 4, or a plurality of probes 6 may be in contact with a plurality of positions of the lower-electrode-exposed part 2a while a plurality of probes 6 may be in contact with a plurality of positions of the upper electrode 4.

Also, in this embodiment, the subjecting the piezoelectric film 3 to polarization is executed prior to applying processing for the devices (see FIG. 16) to the upper electrode 4. That is, the subjecting the piezoelectric film 3 to polarization is performed before the upper electrode 4 is processed into shapes for the devices by photolithography, for example. The subjecting the piezoelectric film 3 to polarization is executed with the entire upper electrode 4 being electrically connected before the upper electrode 4 is electrically separated into the pieces P by processing the upper electrode 4 into the shapes for the devices. According to these processes, the piezoelectric film deposition substrate 100 is manufactured.

In addition, as shown in FIG. 16, when the piezoelectric film deposition substrate 100 is divided into the pieces P for the devices, the piezoelectric film deposition substrate 100 is cut into the pieces P for the devices by using a blade, for example. Applying processing for the devices to the upper electrode 4, the piezoelectric film 3, the lower electrode 2, and the like may be executed before or after the piezoelectric film deposition substrate 100 is divided into the plurality of pieces P. That is, after the piezoelectric film deposition substrate 100 is divided into the plurality of pieces P, processing for the devices may be applied to the upper electrode 4, the piezoelectric film 3, the lower electrode 2, and the like of each of the pieces P divided. Alternatively, after processing for the devices is applied to the upper electrode 4, the piezoelectric film 3, the lower electrode 2, and the like, the piezoelectric film deposition substrate 100 may be divided into the plurality of pieces P. Since the polarization is performed prior to applying processing for the devices to the upper electrode 4, the piezoelectric film 3, the lower electrode 2, and the like, both processes in which the piezoelectric film deposition substrate is divided before and after processing for the devices can be used.

### (Advantages of the Embodiment)

In this embodiment, the following advantages are obtained.

As described above, the method for manufacturing the piezoelectric film deposition substrate 100 according to this embodiment is a method for manufacturing a piezoelectric film deposition substrate 100 to be divided into a plurality of pieces P as devices, the method includes preparing the substrate 1; forming the lower electrode 2 on the substrate 1; attaching a mask 5 on or above the lower electrode 2; forming the piezoelectric film 3 on the lower electrode 2 with the mask 5 being attached on or above the lower electrode 2; forming the upper electrode 4 on the piezoelectric film 3 with the mask 5 being attached on or above the lower electrode 2; forming the lower-electrode-exposed part 2a by removing the mask 5 from the lower electrode 2 to expose a part of the lower electrode 2 on which neither the piezoelectric film 3 nor the upper electrode 4 is formed; and subjecting the piezoelectric film 3 to polarization by applying a voltage between the lower-electrode-exposed part 2a and the upper electrode 4.

According to the aforementioned configuration, it possible to subject the piezoelectric film 3 to polarization by using one operation prior to dividing the piezoelectric film deposition substrate 100 into a plurality of pieces P. Also, since the lower-electrode-exposed part 2a is formed without formation of the piezoelectric film 3 and the upper electrode 4 by using a mask 5, it is possible to easily form the lower-electrode-exposed part 2a without requiring a complicated process as compared with a case in which the lower-electrode-exposed part 2a is formed by photolithography including formation of a resist film and etching of the resist film. Consequently, the lower-electrode-exposed part 2a can be easily formed even in a case in which the piezoelectric film 3 is subjected to polarization by using one operation. In addition, since the piezoelectric film 3 film can be subjected to polarization by using one operation prior to dividing the piezoelectric film deposition substrate 100 into a plurality of pieces P, it possible to reduce time required for polarization of the piezoelectric film 3 as compared with a case in which the piezoelectric film deposition substrate 100 is divided into a plurality of pieces P, and the plurality of pieces P of the piezoelectric film 3 are separately subjected to polarization.

In this embodiment, as described above, the attaching the mask 5 on or above the lower electrode 2 includes attaching the mask 5 on or above at least one part of an outer periphery of the lower electrode 2 that is included in an exclusion area A that is not used as the device; and the forming the lower-electrode-exposed part 2a includes forming the lower-electrode-exposed part 2a in at least one part of the outer periphery of the lower electrode 2, which is included in the exclusion area A. Accordingly, since the lower-electrode-exposed part 2a can be formed by utilizing the exclusion area A, which is not used for the device, it is possible to prevent that an area usable for the device is reduced by formation of the lower-electrode-exposed part 2a. Consequently, it is possible to prevent reduction of a yield of the device. In addition, since the outer periphery of the lower electrode 2 is an area on which the mask 5 can be attached more easily than an inner periphery, it is possible to more easily attach the mask 5.

In this embodiment, as described above, the attaching the mask 5 on or above the lower electrode 2 includes attaching the mask 5 in an arc shape having a fixed curvature on or above the at least one part of the outer periphery of the lower electrode 2; and the forming the lower-electrode-exposed part 2a includes forming the lower-electrode-exposed part 2a in an arc shape having a fixed curvature in the at least one part of the outer periphery of the lower electrode 2. Accordingly, since the lower-electrode-exposed part 2a has an arc shape having a fixed curvature, it is possible to easily form the lower-electrode-exposed part 2a to be included in the exclusion area A.

In this embodiment, as described above, the subjecting the piezoelectric film 3 to polarization includes subjecting the piezoelectric film 3 to polarization by applying the voltage between the lower-electrode-exposed part 2a and the upper electrode 4 prior to applying processing for the device to the upper electrode 4. Accordingly, since polarization can be performed before the upper electrode 4 is electrically separated by applying processing for the device to the upper electrode, an electrically conductive element is not required dissimilar to a case in which the upper electrode 4 is electrically separated by applying processing for the device to the upper electrode, and polarization is then performed by connecting the separated upper electrodes 4 to each other by using the electrically conductive element. Consequently, it is possible to easily perform polarization.

In this embodiment, as described above, the ferroelectric film is the piezoelectric film 3. Accordingly, the lower-electrode-exposed part 2a can be easily formed even in a case in which the piezoelectric film 3 is subjected to polarization by using one operation.

In this embodiment, as described above, the lower electrode 2 includes a lower-electrode-exposed part 2a that is connected to at least one part of an outer periphery of the substrate 1 and on which neither the ferroelectric film 3 nor the upper electrode 4 not is formed; the upper electrode 4 is not subjected to processing for the device; and the piezoelectric film 3 has been subjected to polarization. Accordingly, it possible to provide a piezoelectric film deposition substrate 100 including a piezoelectric film 3 subject to polarization by using one operation prior to dividing the piezoelectric film deposition substrate 100 into a plurality of pieces P. Also, since the lower-electrode-exposed part 2a is formed without formation of the piezoelectric film 3 and the upper electrode 4, it is possible to easily form the lower-electrode-exposed part 2a without requiring a complicated process as compared with a case in which the lower-electrode-exposed part 2a is formed by photolithography including formation of a resist film and etching of the resist film. Consequently, it is possible to provide a piezoelectric film deposition substrate 100 including the lower-electrode-exposed part 2a, which can be easily formed even in a case in which the piezoelectric film 3 is subjected to polarization by using one operation. In addition, since polarization can be performed before pieces of the upper electrode 4 are electrically separated by applying processing for the device to the upper electrode, it is possible to easily perform polarization as compared with a case in which the upper electrode 4 is electrically separated by applying processing for the device to the upper electrode, and polarization is then performed by connecting the separated upper electrodes 4 to each other by using an electrically conductive element.

### [Modified Embodiments]

Note that the embodiment disclosed this time must be considered as illustrative in all points and not restrictive. The scope of the present invention is not shown by the above description of the embodiments but by the scope of claims for patent, and all modifications (modified embodiments) within the meaning and scope equivalent to the scope of claims for patent are further included.

While the example in which a piezoelectric film is used as the ferroelectric film has been shown in the aforementioned embodiment, the present invention is not limited to this. For example, a pyroelectric film may be used as the ferroelectric film.

While the example in which the lower-electrode-exposed part is formed in a part of the outer periphery of the lower electrode that is included in the exclusion area has been shown in the aforementioned embodiment, the present invention is not limited to this. For example, the lower-electrode-exposed part may be formed in a part of the lower electrode that lies inward of the outer periphery.

While the example in which the lower-electrode-exposed part is formed in a ring shape has been shown in the aforementioned embodiment, the present invention is not limited to this. For example, in a first modified embodiment shown in FIG. 17, one arc-shaped lower-electrode-exposed part 2a (having an arc shape with a fixed curvature) is formed in the outer periphery of the lower electrode 2. In this arrangement, in the attaching the mask 5 on or above the lower electrode 2, an arc-shaped mask 5 (having an arc shape with a fixed curvature) is attached on or above the outer periphery of the lower electrode 2. Also, in the forming the lower-electrode-exposed part 2a, an arc-shaped lower-electrode-exposed part 2a (having an arc shape with a fixed curvature) is formed in the outer periphery of the lower electrode 2. Accordingly, since the lower-electrode-exposed part 2a is formed in a relatively narrow area, it is possible to prevent that formation of the lower-electrode-exposed part 2a reduces an area usable for devices. Consequently, it is possible to further prevent reduction of yields of the devices. Also, as in a second modified embodiment shown in FIG. 18, a plurality of (four in FIG. 18) arc-shaped lower-electrode-exposed part 2a (having an arc shape with a fixed curvature) may be formed in the outer periphery of the lower electrode 2.

Also, the lower-electrode-exposed parts according to the aforementioned embodiment, the aforementioned first modified embodiment and the aforementioned second modified embodiment are merely illustrative, and positions, a shape and the number of the lower-electrode-exposed parts are not specifically limited.

While the example in which the piezoelectric film (ferroelectric film) is subjected to polarization prior to applying processing for the device to the upper electrode has been shown in the aforementioned embodiment, the present invention is not limited to this. For example, the ferroelectric film may be subjected to polarization after applying processing for the device to the upper electrode. In this case, the ferroelectric film may be subjected to polarization with the upper electrodes, which are electrically separated by applying processing for the device to the upper electrode, being electrically connected to each other by an electrically conductive element.

### Description of Reference Numerals

1; substrate
2; lower electrode
3; piezoelectric film (ferroelectric film)
4; upper electrode
5; mask
100; piezoelectric film deposition substrate (ferroelectric film deposition substrate)
A; exclusion area
P; piece

## Claims

1. A method for manufacturing a ferroelectric film deposition substrate to be divided into a plurality of pieces as devices, the method comprising:
preparing a substrate;
forming a lower electrode on or above the substrate;
attaching a mask on or above the lower electrode;
forming a ferroelectric film on or above the lower electrode with the mask being attached on or above the lower electrode;
forming an upper electrode on or above the ferroelectric film with the mask being attached on or above the lower electrode;
forming a lower-electrode-exposed part by removing the mask from the lower electrode to expose a part of the lower electrode on or above which neither the ferroelectric film nor the upper electrode is formed; and
subjecting the ferroelectric film to polarization by applying a voltage between the lower-electrode-exposed part and the upper electrode.

2. The method for manufacturing the ferroelectric film deposition substrate according to claim 1, wherein
the attaching the mask on or above the lower electrode includes attaching the mask on or above at least one part of an outer periphery of the lower electrode that is included in an exclusion area that is not used as the device; and
the forming the lower-electrode-exposed part includes forming the lower-electrode-exposed part in the at least one part of the outer periphery of the lower electrode, which is included in the exclusion area.

3. The method for manufacturing the ferroelectric film deposition substrate according to claim 2, wherein
the attaching the mask on or above the lower electrode includes attaching the mask in an arc shape having a fixed curvature on or above the at least one part of the outer periphery of the lower electrode; and
the forming the lower-electrode-exposed part includes forming the lower-electrode-exposed part in the arc shape having the fixed curvature in the at least one part of the outer periphery of the lower electrode.

4. The method for manufacturing the ferroelectric film deposition substrate according to claim 1, wherein the subjecting the ferroelectric film to polarization includes subjecting the ferroelectric film to polarization by applying the voltage between the lower-electrode-exposed part and the upper electrode prior to applying processing for the device to the upper electrode.

5. The method for manufacturing the ferroelectric film deposition substrate according to claim 1, wherein the ferroelectric film is a piezoelectric film.

6. A ferroelectric film deposition substrate to be divided into a plurality of pieces as devices, the ferroelectric film deposition substrate comprising:
a substrate;
a lower electrode formed on or above the substrate;
a ferroelectric film formed on or above the lower electrode; and
an upper electrode formed on or above the ferroelectric film and not subjected to processing for the device, wherein
the lower electrode includes a lower-electrode-exposed part that is connected to at least one part of an outer periphery of the substrate and on or above which neither the ferroelectric film nor the upper electrode is formed, and
the ferroelectric film has been subjected to polarization.
